Europäisches Patentamt

(19) European Patent Office

Office européen des brevets

(11) Publication number: **0 135 384**
**B1**

(12) **EUROPEAN PATENT SPECIFICATION**

(45) Date of publication of patent specification: 08.06.88

(51) Int. Cl.⁴: **G 01 R 1/073**

(21) Application number: **84305937.9**

(22) Date of filing: **30.08.84**

(54) **Probe head assembly.**

(30) Priority: **17.09.83 GB 8324956**

(43) Date of publication of application:
**27.03.85 Bulletin 85/13**

(45) Publication of the grant of the patent:
**08.06.88 Bulletin 88/23**

(84) Designated Contracting States:
**AT BE CH DE FR IT LI LU NL SE**

(56) References cited:
**EP-A-0 026 824**
**EP-A-0 068 493**
**EP-A-0 108 405**
**GB-A-2 085 673**

(73) Proprietor: **MARCONI INSTRUMENTS LIMITED**
**Longacres Hatfield Road**
**St. Albans Hertfordshire, AL4 0JN (GB)**

(72) Inventor: **Jenner, Frank Harry**
**26 Milehouse Lane**
**St. Albans Hertfordshire (GB)**

(74) Representative: **Tolfree, Roger Keith et al**
**GEC p.l.c. Central Patent Department**
**Chelmsford Office Marconi Research Centre**
**West Hanningfield Road**
**Great Baddow Chelmsford Essex CM2 8HN (GB)**

Courier Press, Leamington Spa, England.

## Description

This invention relates to a probe head assembly and is particularly intended for use with circuit boards so as to permit electrical tests and measurements to be performed upon them, either in their original bare state or after electronic components of various kinds have been mounted upon them. It has been customary to produce circuit boards with the inter-connections between conductive tracks and components to be arranged as an array on a regular grid or matrix having a predetermined pitch, typically 0.1 inch (2.5 mm). However, the use of a perfect regular grid array imposes, under some circumstances, an undesirable design constraint and prevents maximum utilisation of the surface area of the circuit board. Accordingly, it has been proposed to design circuit boards in which use is not made of a regular grid, but instead the individual conductive tracks and contact points may lie anywhere on the surface of the board. This makes it extremely expensive to test such a board since one cannot use a regular array of contact probes to make electrical connection with the circuit interconnection points. Various proposals have been made for providing a probe head assembly in which the individual contact points are not arranged on a regular grid, but they suffer from certain disadvantages. A probe array in which the individual contact points do not lie exactly on a regular grid is termed an "off-centre" array.

European patent No. EP-A-0026824 discloses a probe head assembly including a first insulating panel having an off-centre array of apertures, a second insulating panel having an on-centre array of apertures, and a plurality of resiliently deformable elongate conductive members extending between respective apertures in the two panels and arranged to connect test heads mounted in an off-centre array with the off-centre array of a board under test.

However the elongate members are movable relative to the insulating panels and contact with the test heads may be broken as one board is replaced by another for testing, thus, the system has problems of repeatability and consistency of electrical test.

According to this invention there is provided a probe head assembly for use in making electrical connection with a circuit board under test arranged as an off-centre array including a first insulating panel, a second insulating panel mounted parallel to the first insulating panel and a plurality of resiliently deformable elongate conductive members; the second insulating panel being arranged to hold one end of each elongate conductive member in an on-centre array so as to permit their electrical contact with contact heads mounted in a similar on-centre array; characterised in that the first insulating panel carries an off-centre array of probe receptacles each of which includes a resiliently mounted slidable probe which is able in use, to make contact with the circuit board, and that the other end of each elongate conductive member terminates at a respective probe receptacle, each receptacle and associated elongate conductive member being located so as to allow no longitudinal movement of said other end of the elongate conductive member and of the receptacle itself with respect to the first insulating panel.

By the term, "on-centre" array is simply meant an array which conforms to a standard rectangular matrix or grid. The differences in position between the points of an on-centre array and those of the off-centre array are accommodated by distortion in the elongate members. Typically, the elongate members may be narrow, pliable, solid wires or alternatively, they may be thin walled deformable tubes. In each case they must be made of a material which has an excellent electrical conductivity since they serve to connect the individual probes with the contact heads. In practice, the contact heads can form part of a standard testing arrangement which is used for performing measurements in conventional on-centre printed circuit boards. By means of the probe head assembly in accordance with the present invention, the standard equipment can be used to test circuit boards having contact points arranged in an off-centre array. Thus the probe head assembly acts as an interface arrangement.

The invention is further described by way of example, with reference to the accompanying drawings, in which:

Figure 1 is an explanatory diagram,

Figure 2 is a sectional view explaining the operation of one embodiment of a probe head assembly, which is in accordance with the present invention,

Figure 3 is a similar sectional view relating to a further embodiment.

Circuit boards are commonly fabricated using printed circuit techniques in which conductive tracks are formed on one or both sides of a thin insulating board. In practice, many such boards can be formed together to form what is termed a multi-layer printed circuit board. Such circuit boards have an extremely complex pattern of conductive tracks and can carry a very large number of separate electronic components. It is very difficult to test exhaustively such a printed circuit board, both to determine whether the conductive track has been correctly formed so as to provide a low impedance path between required points without making short circuits to neighbouring points, and to establish whether or not all of the electronic components are operating in a correct manner. It has become customary to test circuit boards of this kind by means of a probe head assembly, sometimes termed a 'bed of nails' in which a very large number of individual electrical probes, usually spring loaded, are arranged in an array and are wired into a large testing machine which is capable of applying particular voltages or current to selected probes which contact specific points of the circuit board. By monitoring the resultant voltages and currents induced in the circuit board and its components, its electrical performance can be assessed. In order to increase the packing density of components upon a circuit board and to increase the complexity of electrical tracks between such points, it is becoming standard practice to dispense with a regular grid array and simply to position the tracks and interconnection points at those locations which are most suited to the operation of the circuit board and the packing density required.

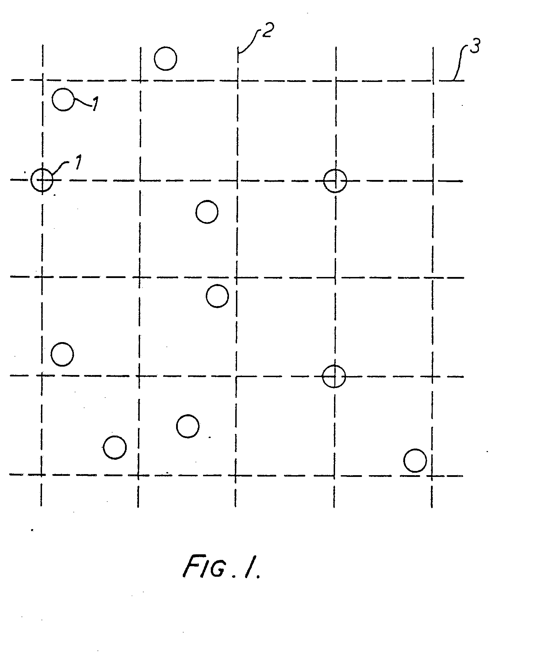

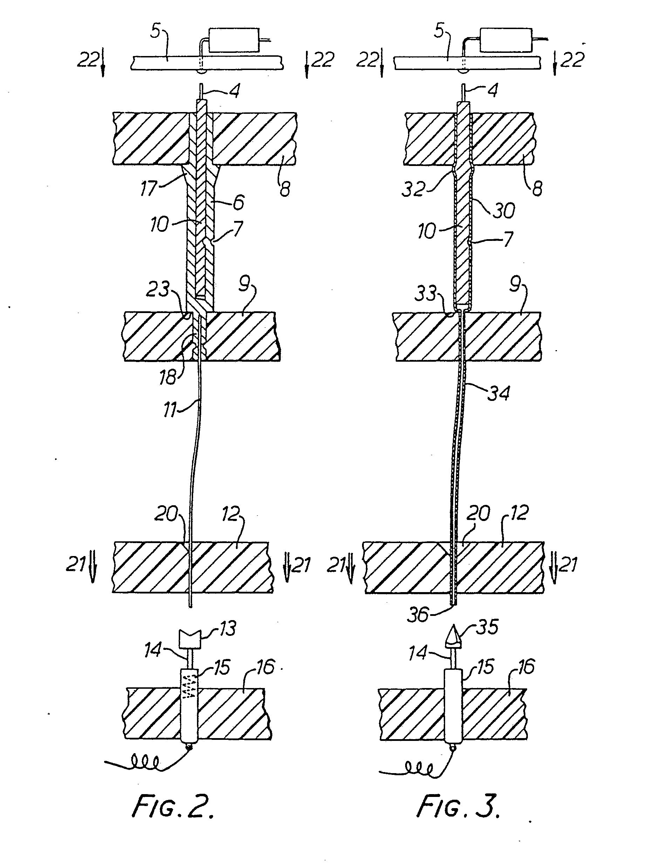

In Figure 1, the actual points of a printed circuit board to which electrical contact is to be made by a testing instrument is indicated by the solid circles 1, and they do not lie exactly upon a regular. 1″ grid which is represented by the broken vertical lines 2 and the horizontal lines 3. In order to permit the testing of components lying on an off-centre array which is made up of a large number of points corresponding to the circles 1, the probe head assembly which is illustrated in Figure 2 is used.

Referring to Figure 2, a large number of individually resiliently mounted (spring loaded) contact probes 4 are mounted so that they contact specific regions of a printed circuit board 5. For ease of illustration only a single probe 4 is illustrated. The probe 4 is located slideably within a probe receptable 6, and its housing 10 is retained within the receptacle by means of a small deformation 7. The receptable 6 itself has a small barb 17 upon it which secures it tightly within a panel 8 made of a soft insulating plastic material. In practice, the receptacle 6 is pushed through a pre-drilled aperture in the panel 8, the aperture being temporarily distorted as the barb passes through it in a downwards direction. The barb holds the receptacle firmly against the underside of the panel 8 and is prevented from moving upwards. Each receptacle is attached to one end of a resiliently deformable elongate conductive solid wire 11, the other ends of which are located by a second insulating panel 12. The base 18 of the receptable 6 is located in a corresponding aperture in a further insulating panel 9 which is parallel to the first panel 8, and is prevented from longitudinal end movement by the stop 23.

Thus, both panels 8 and 9 contain a large number of aligned small apertures arranged on the off-centre array which corresponds to the desired contact points on the underside of the printed circuit board 5. The panels 8 and 9 are carefully aligned so that the probe receptacles, and hence the axis of each slidable probe 4 is precisely normal to the upper panel 8.

The thin solid wire 11 is crimped to the base 18 of the probe receptacle 6. In practice, the wire 11 may have an appreciable length, i.e. 5 or 6 centimetres, and it is of a relatively pliable material which is nevertheless resilient.

The lower end of the wire 11 passes through a small aperture drilled in the second insulating panel 12 and it is positioned immediately above a resiliently mounted (spring loaded) contact head 13 which is located on a stem 14 which is slidable within a further housing 15, which in turn is firmly clamped to a further electrically insulating panel 16. The holes in the panels 12 and 16 are positioned on a regular array, i.e. an on-centre array, which conforms to the standard array used by many test machines. Thus, the contact head permits a standard on-centre array to be used to make electrical connection with a circuit board having desired contact points positioned on a non-standard off-centre array. The contact heads do not form part of the probe head assembly itself, but in practice would form part of, or are associated with, the test machine.

The two panels 8 and 9 are unique to a particular circuit board to be tested, and the required array of off-centre apertures is drilled when the requirements of the testing operation have been established. Both panels 8 and 9 are drilled so that the apertures in each align exactly with each other, and they are then mounted together rigidly, by means not shown, so that they are spaced apart by the correct amount from each other by the length of the receptacles 6. The wires 11 form part of their respective receptacles, and in practice there could be an extremely large number, e.g. well in excess of a thousand, and the ends of the wires are then passed through the apertures in the panels 8 and 9 until the barbs 17 locate on the underside of the upper panel 8 and the step 23 rests against the second panel 9. The free ends of the wires 11 are fed through the appropriate aperture in the panel 12, the apertures being surrounded by a large area cone-shaped depression 20, which is of sufficient size to "capture" the free end of the initially undistorted wire 11. The wire 11 distorts as it is fed through the panel 12, and so adopts the shape shown in Figure 2. The panel 12 is of appreciable thickness so that the lower end of the wire 11 which projects from it is normal to the panel 12, and its end aligns with the on-centre contact head 13. The panel 9 is mounted at a fixed distance from the panel 12.

The complete assembly of panels 8, 9 and 12 is then moved in the direction of the arrows 21 to make good electrical contact between the ends of the wires 11 and the spring loaded contact heads 13. Once made, this contact is not disturbed until the panels 8 and 9 are removed to permit a different kind of circuit board to be tested. This aspect greatly contributes to the reliability of the electrical paths so formed, and the consistency of the electrical tests which are performed.

In practice, a large number of similar circuit boards 5 will be tested one after the other, and each is brought into contact with the array of probes 4 by moving the board down in the direction of the arrows 22, the resilience of the slidable probes accommodating non-uniformities in the lower surface of the circuit board.

It will be appreciated that the maximum number of possible contact points is determined by the number of on-centre points as determined by the number of contact heads 13, and that each probe 4 must be associated with a particular one of the contact heads.

When it is desired to test another type of printed circuit board having a different circuit configuration, it is necessary to produce two new panels 8 and 9 which carry the appropriate array of off-centre apertures to accommodate the probe receptacles. The probe receptacles 6 and the elongate wires 11, together with the spring loaded probe heads 4, represent the bulk of the cost of the assembly — each item is a precision component formed out of a material such as beryllium copper or a nickel-silver material, and in practice many thousand such electrical paths may be required in a single probe head assembly. Each probe receptacle with its attached wire 11 can be withdrawn from the panels 8 and 9, and the natural resilience of the deformed wire 11 allows it to revert to its original straight shape, thereby permitting its reuse in the new panels, panel 12 is, of course, also reusable, as are the means (not shown) which secure the three panels 8, 9, 12 together.

Figure 3 shows an alternative embodiment of the invention, which is basically similar to that shown in Figure 2, but it uses an alternative form of probe receptacle and elongate member. Those parts which are the same as in Figure 2 carry the same reference numerals. ·

The probe receptacle and the elongate member are formed as a single hollow tube, having a relatively wide upper portion 30 within which the housing of the probe 4 is mounted and held in place by means of a small deformation 7 in the tube portion 30. The portion 30 is held against the underside of the panel 8 by means of a locally raised collar 32, and is prevented from moving longitudinally with respect to the panel 9 by means of the shoulder 33 which serves as a transition between the wide upper portion 30, and a narrow lower portion 34. The portion 34 of the hollow tube is resiliently deformable in a manner similar to the wire 11 of Figure 2, and its end is located in an "on-centre" aperture in panel 12.

An alternative form of contact head is used — it consists of an upward-pointing cone with three facets, the central point of which enters the lower end 36 of the hollow tube. It may also be used in conjunction with a hollow end to wire 11 in Figure 2. This configuration gives a very good and reliable electrical contact, is easily cleaned and reduces the likelihood of dirt accumulating on the contact surfaces. As before, a semi-permanent connection is maintained by the ends 36 and the contact heads 35 whilst a series of similar circuit boards are tested by being brought in turn into contact with the probes 4. Only at the end of the series of tests is the connection with the contact heads 35 broken.

By analogy with Figure 2, each hollow tube can be withdrawn from the three panels 8, 9, 12, whereupon it regains its straight shape due to its natural resilience. Thus the tubes, and their associated probes, can be reused many times, along with the panel 12. In principle, the panels 8 and 9 can also be reused if it is desired to test the same kind of circuit board after an interval during which other kinds of circuit board have been tested.

## Claims

1. A probe head assembly for use in making electrical connection with a circuit board under test arranged as an off-centre array including a first insulating panel (8) a second insulating panel (12) mounted parallel to the first insulating panel and a plurality of resiliently deformable elongate conductive members (11, 34); the second insulating panel being arranged to hold one end of each elongate conductive member in an on-centre array so as to permit their electrical contact with contact heads (13, 35) mounted in a similar on-centre array; characterised in that the first insulating panel carries an off-centre array of probe receptacles (6) each of which includes a resiliently mounted slidable probe (4) which is able, in use, to make contact with the circuit board, and that the other end of each elongate conductive member terminates at a respective probe receptacle, each receptacle and associated elongate conductive member being located so as to allow no longitudinal movement of said other end of the elongate conductive member and of the receptacle itself with respect to the first insulating panel.

2. An assembly as claimed in claim 1 and wherein said second insulating panel is arranged to hold said ends of the elongate conductive members normal to the plane of the panel.

3. An assembly as claimed in claim 2 and wherein said second insulating panel has an array of apertures corresponding to said on-centre array so that said ends protrude through respective ones of the apertures.

4. An assembly as claimed in claim 3 and wherein the side of each aperture in said second insulating panel facing the receptacles is surrounded by a dished region (20) which serves to guide said ends of the elongate conductive members into and through said apertures during assembly.

5. An assembly as claimed in claim 1, 2, 3 or 4 and wherein a further insulating panel (9) is provided having an off-centre array of apertures which serve to locate the ends of said receptacles remote said first panel so as to hold the receptacles normal thereto.

6. An assembly as claimed in any of the preceding claims and wherein each elongate conductive member is a thin solid wire.

7. An assembly as claimed in any of claims 1 to 5 and wherein each elongate conductive member is a thin walled tube.

8. An assembly as claimed in claim 7 and wherein each probe receptacle is formed as a tube which is unitary with said thin walled tube which constitutes said elongate conductive member.

## Patentansprüche

1. Tastkopfanordnung zur Verwendung bei der Herstellung elektrischer Verbindungen mit einer zu untersuchenden Schaltplatine, die als eine ungeordnete Verteilung ausgelegt ist, mit einer ersten isolierenden Tafel (8), einer parallel zu der ersten isolierenden Tafel angebrachten zweiten isolierenden Tafel (12) und einer Vielzahl von elastisch verformbaren länglichen leitenden Elementen (11, 34), wobei die zweite isolierende Tafel ausgelegt ist, ein Ende jedes länglichen leitenden Elementes in einer geordneten Verteilung so zu halten, daß deren elektrischer Kontakt mit in einer gleichartigen geordneten Verteilung angebrachten Kontaktköpfen (13, 35) zugelassen ist, dadurch gekennzeichnet, daß die erste isolierende Tafel eine ungeordnete Verteilung von Sondenaufnahmen (6) trägt, von denen jede eine elastisch angebrachte gleitbare Sonde (4) enthält, die in Gebrauch zur Kontaktbildung mit der Schaltplatine befähigt ist, und daß das andere Ende jedes länglichen leitenden Elementes in einer jeweiligen Sondenaufnahme endet, wobei jede Aufnahme und das zugehörige längliche leitende Element so angeordnet sind, daß keine Längsbewegung des anderen Ende des länglichen leitenden Elementes und der Aufnahme selbst bezüglich der ersten isolierenden Tafel zugelassen ist.

2. Anordnung nach Anspruch 1, und bei der die zweite isolierende Tafel ausgelegt ist, die Enden der länglichen leitenden Elemente senkrecht zur Ebene der Tafel zu halten.

3. Anordnung nach Anspruch 2, und bei der die zweite isolierende Tafel eine Anordnung von Durchbrüchen entsprechend der geordneten Verteilung besitzt, so daß jedes Ende durch jeweils einen Durchbruch vorsteht.

4. Anordnung nach Anspruch 3, und bei der die den Aufnahmen zugewendete Seite jedes Durchbruches in der zweiten isolierenden Tafel von einem vertieften Bereich (20) umgeben ist, der zur Führung der Enden der länglichen leitenden Elemente in und durch die Durchbrüche während des Zusammenbaus dient.

5. Anordnung nach Anspruch 1, 2, 3 oder 4, und bei der eine weitere isolierende Tafel (9) vorgesehen ist mit einer ungeordneten Verteilung von Durchbrüchen, die zur Lokalisierung der von der ersten Tafel abgelegenen Enden der Aufnahmen dienen, um so die Aufnahmen senkrecht dazu zu halten.

6. Anordnung nach einem der vorangehenden Ansprüche, und bei der jedes längliche leitende Element ein dünner massiver Draht ist.

7. Anordnung nach einem der Ansprüche 1 bis 5 und bei der jedes längliche leitende Element eine dünnwandige Röhre ist.

8. Anordnung nach Anspruch 7, und bei der jede Sondenaufnahme als eine mit der dünnwandigen Röhre, die das längliche leitende Element bildet, einheitliche Röhre ausgebildet ist.

## Revendications

1. Ensemble à têtes ou pointes d'essai pour établir des liaisons électriques avec une plaque de circuits imprimés ou carte imprimée à contrôler, les pointes d'essai ayant une disposition décentrée, ne correspondant pas à une grille régulière, ensemble qui comprend une première plaque isolante (8), une seconde plaque isolante (12) montée parallèle à la première et des éléments conducteurs (11, 34) de forme allongée et élastiquement déformables, la seconde plaque isolante étant conçue pour maintenir une extrémité de chaque élément conducteur dans une disposition centrée, correspondant à une grille, de façon à permettre le contact électrique des extrémités des éléments conducteurs avec des têtes de contact (13, 35) montées dans une disposition centrée semblable, caractérisé en ce que la première plaque isolante porte une disposition décentrée de récepteurs de pointes (6), contenant chacun une pointe d'essai (4) montée élastiquement coulissante et qui est destinée à s'appliquer contre la carte imprimée, et que l'autre extrémité de chaque élément conducteur allongé est située sur un récepteur de pointe respectif, chaque récepteur et l'élément conducteur associé étant montés de façon à ne permettre aucun mouvement longitudinal de cette autre extrémité et du récepteur lui-même par rapport à la première plaque isolante.

2. Ensemble selon la revendication 1 et dans lequel la seconde plaque isolante est conçue pour maintenir lesdites extrémités des éléments conducteurs normales au plan de la plaque.

3. Ensemble selon la revendication 2 et dans lequel la seconde plaque isolante présente des trous ménagés suivant ladite disposition centrée, de sorte que les extrémités des éléments conducteurs dépassent chacune à travers un trou respectif.

4. Ensemble selon la revendication 3 et dans lequel chaque trou de la seconde plaque isolante est entouré, du côté dirigé vers les récepteurs, par un évasement (20) qui sert à guider lesdites extrémités des éléments conducteurs allongés dans et à travers les trous pendant l'assemblage.

5. Ensemble selon la revendication 1, 2, 3 ou 4 et dans lequel est prévue une autre plaque isolante (9) possédant une disposition décentrée de trous qui servent à positionner les extrémités des récepteurs éloignées de la première plaque, de manière à maintenir les récepteurs normaux à cette première plaque.

6. Ensemble selon l'une quelconque des revendications précédentes et dans lequel chaque élément conducteur allongé est un mince fil massif.

7. Ensemble selon l'une quelconque des revendications 1 à 5 et dans lequel chaque élément conducteur allongé est un tube à faible épaisseur de paroi.

8. Ensemble selon la revendication 7 et dans lequel chaque récepteur de pointe est formé comme un tube qui est d'un seul tenant avec le tube à faible épaisseur de paroi qui constitue l'élément conducteur.

FIG. 1.

FIG.2.

FIG.3.